(19) **Europäisches Patentamt**

**European Patent Office**

**Office européen des brevets**

(11) **EP 1 304 806 B1**

(12) **EUROPEAN PATENT SPECIFICATION**

(45) Date of publication and mention
of the grant of the patent:
**07.06.2006 Bulletin 2006/23**

(51) Int Cl.:
**H03L 1/02** (2006.01)

(21) Application number: **02102420.3**

(22) Date of filing: **07.10.2002**

(54) **Integrated temperature compensated crystal oscillator circuit**

Integrierte temperaturkompensierte Kristalloszillatorschaltung

Circuit intégré d'oscillateur à cristal compensé en température

(84) Designated Contracting States:
**AT BE BG CH CY CZ DE DK EE ES FI FR GB GR
IE IT LI LU MC NL PT SE SK TR**

(30) Priority: **12.10.2001 FI 20011991**

(43) Date of publication of application:
**23.04.2003 Bulletin 2003/17**

(73) Proprietor: **Micro Analog Systems OY
02770 Espoo (FI)**

(72) Inventors:
• **Sillanpää, Tero
00800, Helsinki (FI)**
• **Beeler, Daniel
8733, Eschenbach (CH)**

(74) Representative: **Äkräs, Tapio Juhani
Oy Kolster Ab,
Iso Roobertinkatu 23,
P.O. Box 148
00121 Helsinki (FI)**

(56) References cited:
**EP-A- 0 913 945          EP-A- 1 107 455
US-A- 4 833 426          US-A- 5 977 840**

**Description**

The invention relates to integrated crystal oscillator circuits, and especially to temperature compensated crystal oscillator circuits.

Voltage-controlled crystal oscillators (VCXO) are widely used in electronical devices, e.g. for generating a system clock or a reference frequency, in frequency synthesisers, etc. A basic crystal oscillator typically includes a crystal, a varactor diode and some kind of amplifier. The oscillation frequency of such an oscillator is controlled by the voltage appearing across the varactor diode. In many applications the accuracy requirements for the output frequence of the voltage-controlled crystal oscillator VCXO are very strict. One of the factors which affect the accuracy of the VCXO is the temperature. Especially the capacitance exhibited by the varactor and thereby the oscillation frequency of the oscillator change with the temperature.

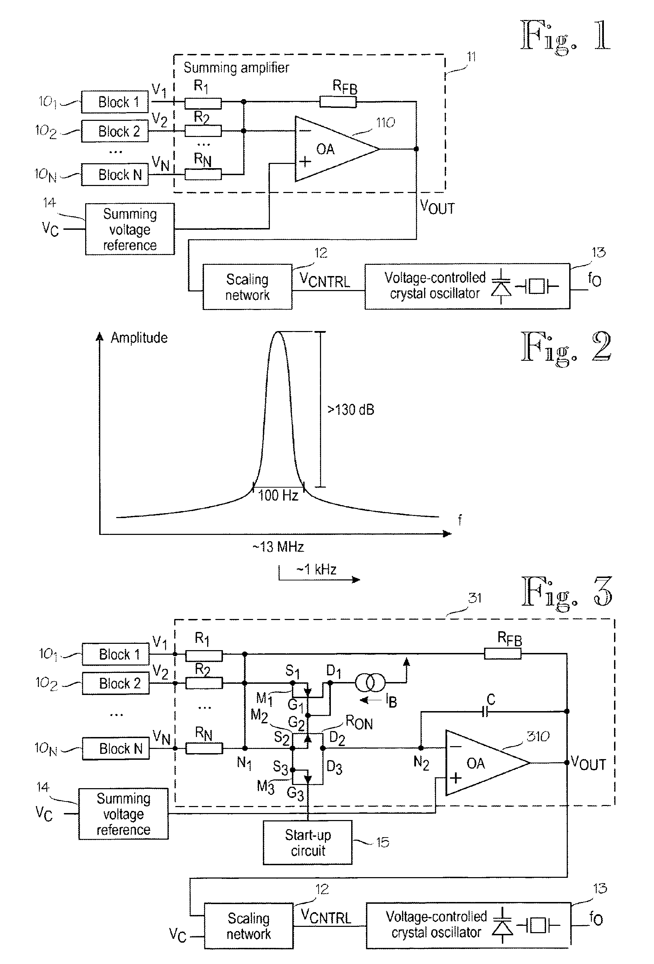

In a temperature compensated voltage-controlled crystal oscillator (TCVCXO), the control voltage of the crystal oscillator is varied depending on the temperature so that the effect of the temperature on the output frequency is compensated. In other words, the control voltage is dependent on the temperature so that the capacitance exhibited by the varactor diode is substantially constant when the temperature varies. As a result, also the output frequency of the crystal oscillator is substantially constant. Figure 1 illustrates a prior art TCVCXO. Various temperature-dependent control voltages V1, V2 and VN from generator blocks $10_1$, $10_2$ and $10_N$ are added by a summing amplifier 11 to provide a control voltage $V_{CNTRL}$ for a varactor diode in the voltage-controlled crystal oscillator 13 in order to cancel the temperature dependency of the crystal oscillator frequency $f_0$. The simplified configuration of the summing amplifier 11 comprises series resistors $R_1$, $R_2$ and $R_N$ for connecting the voltages $V_1$, $V_2$ and $V_N$, respectively, to the inverting input of an operational amplifier 110. A feedback resistor $R_{FB}$ is connected between the inverting input and the output of the operational amplifier 110. A reference voltage from a summing voltage reference 14 is applied to the non-inverting input of the operational amplifier 110. There may be an additional scaling network between the output of the amplifier 11 and the control input of the oscillator 13. A voltage reference for the summing amplifier 11 is generated in a summing voltage reference generator 14. An external control voltage $V_c$ is applied to the summing amplifier 11 through the summing voltage reference generator. EP 0913 945 discloses such oscillator.

A problem the inventor has observed in such a temperature compensated crystal oscillator circuit is that it introduces noise into the control voltage $V_{CNTRL}$. The noise in the control voltage causes jitter at the oscillator frequency $f_o$. This is noticed as phase noise in the oscillator output signal. The phase noise of a good TCVCXO should be 130 dB below a fundamental oscillation amplitude at a 100 Hz distance from the fundamental frequency (see Figure 2).

An object of the invention is a temperature compensated crystal oscillator circuit with reduced phase noise in the oscillator output signal.

This object is achieved with a temperature compensated crystal oscillator which is characterized by what is disclosed in claim 1. Preferred embodiments of the invention are disclosed in the attached dependent claims.

The inventor has observed that a primary source of the noise is provided by the control voltage generator blocks. The control circuit does not attenuate noise within the bandwidth of the summing amplifier, and therefore the noise from the blocks connected to inputs of a summing amplifier is added to the control voltage outputted from the temperature control circuit to the crystal oscillator. One approach to solving this problem is of course to reduce the noise in the noise sources, i.e. the control signal generators. The approach according to the invention to reducing phase noise is to add a low-pass filter on the signal path between the noise sources and the crystal oscillator. The temperature-dependent control voltage from the generator changes so slowly that low-pass filtering with a low corner frequency, such as 10 Hz, would not affect the performance of the temperature compensated crystal oscillator in operation. The main problem is how to implement an integrated low-pass filter with a very low corner frequency.

According to the present invention, an integrated low-pass filter is added in a summing amplifier of a temperature compensated voltage-controlled crystal oscillator circuit. A very high-value integrated resistance is provided at the input of the summing amplifier so that the control voltages to be summed are applied through respective series resistors to one terminal of said integrated resistance and then further through the integrated resistance to the inverting input of the summing amplifier. Further, a feedback capacitor is connected between the inverting input and an output of the summing amplifier. In the preferred embodiment of the invention, the integrated resistance is provided by the on-resistance of a mosfet transistor.

As a result, a low-pass filter with a very low corner frequency is obtained, and the noise phase in the output frequency of the voltage-controlled crystal oscillator is reduced.

A problem caused by the integrated low-pass filter with a low corner frequency is that the start-up of the circuit is much slower than before, i.e. when a supply voltage of the circuit is switched on, there is a step input to the summing amplifier but the output voltage of the amplifier will reach a static value relatively slowly. In an embodiment of the invention, the integrated low-pass filter is provided with a shunting mechanism for shunting the integrated resistance at the start-up of the oscillator circuit. In an preferred embodiment of the invention, the shunting mechanism comprises a transistor connected across the integrated resistance and arranged to be switched on to a conductive state at the start-up of the oscillator circuit. When the transistor is on, a relatively low resistance is provided at the input of the amplifier, and therefore the corner frequency of the integrated filter is set to a much higher frequency and the output of the summing amplifier will settle much faster. After settling, the shunting mechanism is switched off and the corner frequency is set to the low frequency.

In the following, the invention will be described in greater detail by means of preferred embodiments with reference to the accompanying drawings, in which

Figure 1 illustrates a block diagram of a prior art temperature compensated voltage-controlled crystal oscillator,
Figure 2 is a graph which illustrates the phase noise attenuation requirements of a TCVCXO, and
Figure 3 is a block diagram of a temperature compensated voltage-controlled crystal oscillator circuit according to the preferred embodiment of the invention.

In Figure 3, there are N blocks $10_1$, $10_2$...$10_N$ delivering voltages $V_1$, $V_2$ and $V_N$ to the inputs of a summing amplifier 31. The blocks $10_1$ - $10_N$ may be delivering either constant voltages or temperature-dependent voltages. The temperature dependency of the voltages $V_1$ - $V_N$ may be based on any suitable function and have any suitable shape.

According a preferred embodiment of the invention, the number N of the blocks $10_1$ - $10_N$ is 4. The first block $10_1$ may be a cubic generator generating a temperature-dependent voltage $V_1$, so that the output voltage $V_{OUT}$ is a 3-order polynomial with a variable of temperature. The second block $10_2$ may be a voltage reference generating a temperature-independent voltage $V_2$. In practice, this voltage may be derived from a summing voltage reference block 14. The third block $10_3$ may be a linear generator generating a voltage $V_3$ which is linearly dependent on the temperature. The fourth block $10_4$ may be a ground connection.

Within the summing amplifier 31, each of the voltages $V_1$, $V_2$ and $V_N$ is connected to a circuit node N1 through respective series resistors $R_1$, $R_2$ and $R_N$. A high integrated resistance $R_{ON}$ according to the present invention is connected between the node N1 and a second circuit node N2, which is further connected to an inverting input of an operational amplifier 310. A feedback capacitor C is connected between node N2 and the output of the amplifier 310. A feedback resistor $R_{FB}$ is connected between node N1 and the output of the amplifier 310. A voltage reference is generated for the summing amplifier 31 by a summing voltage reference generator 14. A voltage reference may be either constant or temperature-dependent. An external control voltage $V_c$ is applied to the summing amplifier through the summing voltage reference generator. The voltage $V_c$ is an external control voltage used for controlling the oscillator frequency $f_O$ of the TCVCXO. If the control voltage $V_c$ is constant, the frequency of the oscillator does not change from the temperature compensated frequency.

The output of the summing amplifier 31 is connected to the control voltage input of a crystal oscillator 13 either directly or through a scaling network 12. The crystal oscillator 13 has a crystal, a varactor and some kind of amplifier. The type of the oscillator 13 is not relevant to the present invention; it can be any type of voltage-controlled crystal oscillator with a varactor diode.

The circuitry according to Figure 3 is typically implemented on an integrated circuit chip with a minimum amount of external components. Such external components may include the crystal and a capacitor having a high capacitance value. External components are not desired, because they are space consuming, expensive, require external connections, and provide potential interference sources. Therefore, it is preferable to provide the noise filtering according to the invention on an integrated chip without any additional external components. In the preferred embodiment of the invention, the high resistance $R_{ON}$ is an on-resistance of a mosfet M2 connected between nodes N1 and N2 and biased with a low gate-to-source voltage. More particularly, the source electrode S2 of M2 is connected to circuit node N1, and the drain electrode D2 is connected to circuit node N2. The mosfet M2 is biased with a matching diode-connected mosfet M1 which has a small current source $I_B$. More specifically, the source electrode S1 of M1 is connected to circuit node N1, gate G1 is connected to gate G2 of M2, and the drain D1 is connected to a current source $I_B$. Further, the drain and gate electrodes of M1 are interconnected.

Let us now consider the operation of the summing amplifier 31 in more detail. There are N blocks delivering voltages to the inputs of the summing amplifier 31. The summing amplifier 31 will sum input voltages according to the equation

$$V_{OUT} = \sum_{n=1}^{N} \left( -\frac{R_{FB}}{R_n} \cdot \frac{1}{1 + s \cdot R_{ON} C (1 + \frac{R_{FB}}{R_n} + \frac{R_{FB}}{R_{ON}})} \cdot V_{n1} \right),$$

in which $R_{ON}$ is the on-resistance of the mosfet transistor M2, s is complex angular speed; $V_{n1}$ are the input voltages, and $R_n$.are the respective series resistors. If the transistor M2 is biased with a low $V_{GS}$ voltage, it is possible to have $R_{ON} \gg R_n, R_{FB}$. From the above equation it can be seen that the DC gain of the amplifier 31 is set accurately by the resistance ratio of $R_{FB}/R_n$, and the low-pass corner frequency of the integrated low-pass filter is set approximately by the time constant $R_{ON} C(1+ R_{FB}/R_n)$. The increasing gain decreases the corner frequency by same amount, thereby keeping the -20 dB/decade roll-of slope of the filter unnaffected. Therefore the roll-of slope may be set independently of the gain setting.

The mosfet on-resistance is

$$R_{ON} = \frac{L}{\mu_o \cdot C_{ox} \cdot W(V_{GS} - V_{th})},$$

in which $\mu_o$ is mobility of the charger in bulk, $C_{ox}$ is gate oxide capacitance, W/L is transistor gate width and length ratio, $V_{GS}$ is gate-to-source voltage and $V_{th}$ is transistor threshold voltage. By setting the M1 and M2 ratio relatively high and the bias current $I_B$ relatively low, a resistor value of several 100 Mohms is easily available. This resistance $R_{ON}$ will itself generate noise, but it is low-pass filtered in the filter itself. As a result, it is possible to reduce the total noise at the output of the summing amplifier 31 at frequencies higher than the corner frequency.

Let us take some possible values as an example. Let $R_{ON}$ = 100 Mohm, C = 100 pF, $R_{FB}/R_n$ = 100kohm/ 100kohm = 1. The DC gain will be 0 dB, and the corner frequency is approximately 8 Hz. The attenuation is over 20dB already at 100 Hz, and the jitter caused by the blocks 10 is attenuated more than 20dB. The mosfet on-resistance $R_{ON}$ will add some noise to the control voltage $V_{CNTR}$ but it is also attenuated more than 20 dB. If this attenuated on-resistance noise is less than the non-filtered block noise, the total noise is reduced.

Because heavy low-pass filtering will slow the start-up of the oscillator circuit remarkably, a mosfet transistor M3 is connected in parallel with transistor M2. More specifically, source S3 and drain D3 are connected to source S2 and drain D2, respectively, of transistor M2. The start-up circuit 15 is connected to the gate 3 of transistor M3. When the supply voltage is switched on, the start-up circuit 15 provides a short voltage pulse to gate G3 of transistor M3, causing a conducting state in transistor M3 for the duration of the voltage pulse. In the conducting state, transistor M3 shunts transistor M2 and provides a low resistance between nodes N1 and N2. As a consequence, the corner frequency of the filter is set to a much higher frequency and the output $V_{OUT}$ of the summing amplifier 31 will settle much faster. After settling, the control voltage at gate G3 of transistor M3 is disabled (i.e. the voltage pulse ends), transistor M3 becomes non-conductive, the high resistance $R_{ON}$ is provided between nodes N1 and N2, and thereby the corner frequency is set to the low frequency for filtering the phase noise.

It should be appreciated that the description only illustrates the preferred embodiments of the invention. The invention is not, however, limited to these examples, but it may vary within the scope of the appended claims.

**Claims**

1.  An integrated temperature compensated crystal oscillator circuit comprising
    a first generator (10) generating a first temperature-dependent control voltage,
    a second generator (10) generating a second temperature-dependent control voltage,
    a summing amplifier (31) comprising an operational amplifier (310) and having first and second inputs for receiving said first and second control voltages ($V_1$, $V_2$), respectively, and an output for outputting a sum voltage ($V_{OUT}$) to be used as a frequency control voltage, ($V_{CNTRL}$),
    a third circuit (14) generating a reference voltage for a non-inverting input of said operational amplifier (310),
    a voltage-controlled crystal oscillator (13) having a control input operationally connected to receive said frequency control voltage ($V_{CNTRL}$) **characterized in that** said summing amplifier (31) includes an integrated low-pass filter which comprises
    an integrated component (M$_2$) having a high resistance value, said component having a first terminal (D$_2$) connected to an inverting input of said operational amplifier (310), and a second terminal (S$_2$) connected to a circuit node (N1) which is further connected to said first input through a first series resistor (R$_1$) and to said second input through a second series resistor (R$_2$),
    a feedback capacitor (C) connected between the inverting input and the output of said operational amplifier (310).

2.  An oscillator circuit as claimed in claim 1, **characterized by** a shunting mechanism (M3) for shunting said component

(M$_2$) at start-up of the oscillator circuit.

3. An oscillator circuit as claimed in claim 2, **characterized in that** said shunting mechanism comprises a transistor (M3) connected between said circuit node (N1) and said inverting input and arranged to be switched on at the start of the oscillator circuit.

4. An oscillator circuit as claimed in claim 1, 2 or 3, **characterized in that** said component is a mosfet transistor (M2) and said high resistance is the on-resistance of said mosfet.

5. An oscillator circuit as claimed in claim 1, 2 or 3, **characterized in that** said integrated component comprises a transistor (M2) having a first main electrode (S2) connected to said circuit node (N1), and a second main electrode (D2) connected to said inverting input, said transistor (M2) being biased to provide said high resistance value.

6. An oscillator circuit as claimed in any one of claims 1 to 5, **characterized in that** said integrated component comprises a mosfet transistor (M2) biased with a gate-to-source voltage, said mosfet transistor (M2) having a source (S2) connected to said circuit node (N1), and a drain (D2) connected to said inverting input.

7. An oscillator circuit as claimed in claim 6, **characterized in that** said mosfet transistor (M2) is biased by a second diode-connected mosfet transistor (M1) having a source (S1) connected to said circuit node (N1), a gate (G1) connected to a gate (G2) of said mosfet transistor (M2), and a drain (D2) connected to a biasing current source (I$_B$) to said gate (G2) of said second mosfet transistor (M1).

8. An oscillator circuit as claimed in any one of claims 1 to 7, **characterized in that** a corner frequency of said low-pass filter is lower than 10 Hz.

9. An oscillator circuit as claimed in any one of claims 1 to 8, **characterized in that** said high resistance value of said component is higher than 50 Mohms, preferably higher than 100 Mohms.

**Patentansprüche**

1. Integrierte temperaturkompensierte Kristalloszillatorschaltung, mit:

einem ersten Generator (10), der eine erste temperaturabhängige Steuerspannung erzeugt,
einem zweiten Generator (10), der eine zweite temperaturabhängige Steuerspannung erzeugt,
einem Summierverstärker (31), der einen Operationsverstärker (310) umfasst und aufweist: erste und zweite Eingänge zum Empfangen der ersten bzw. zweiten Steuerspannungen (V$_1$, V$_2$) und einen Ausgang zum Ausgeben einer Summenspannung (V$_{OUT}$), die als eine Frequenzsteuerspannung (V$_{CNTRL}$) zu verwenden ist;
einer dritten Schaltung (14), die eine Bezugsspannung für einen nichtinvertierenden Eingang des Operationsverstärker (310) erzeugt,
einem spannungsgesteuerten Kristalloszillator (13), der einen Steuereingang aufweist, der funktionsmäßig verbunden ist, um die Frequenzsteuerspannung (V$_{CNTRL}$) zu empfangen, **dadurch gekennzeichnet, dass** der Summierverstärker (31) ein integriertes Tiefpassfilter aufweist, das umfasst:

ein integriertes Bauteil (M$_2$) mit einem hohen Widerstandswert, wobei das Bauteil aufweist: einen ersten Anschluss (D$_2$), der mit einem invertierenden Eingang des Operationsverstärker (310) verbunden ist, und einen zweiten Anschluss (S$_2$), der mit einem Schaltungsknoten (N1) verbunden ist, der ferner mit dem ersten Eingang durch einen ersten Reihenwiderstand (R$_1$) und mit dem zweiten Eingang durch einen zweiten Reihenwiderstand (R$_2$) verbunden ist, und
einem Rückkopplungskondensator (C), der zwischen dem invertierenden Eingang und dem Ausgang des Operationsverstärker (310) verbunden ist.

2. Oszillatorschaltung gemäß Anspruch 1, **gekennzeichnet durch** einen Nebenschlussmechanismus (M3) zum Nebenschließen des Bauteils (M2) beim Einschalten der Oszillatorschaltung.

3. Oszillatorschaltung gemäß Anspruch 2, **dadurch gekennzeichnet, dass** der Nebenschlussmechanismus einen Transistor (M3) umfasst, der zwischen dem Schaltungsknoten (N1) und dem invertierenden Eingang geschaltet und angeordnet ist, um beim Start der Oszillatorschaltung angeschaltet zu werden.

4. Oszillatorschaltung gemäß Anspruch 1, 2 oder 3, **dadurch gekennzeichnet, dass** das Bauteil ein MOSFET-Transistor (M2) und der hohe Widerstand der Ein-Widerstand des MOSFET ist.

5. Oszillatorschaltung gemäß Anspruch 1, 2 oder 3, **dadurch gekennzeichnet, dass** das integrierte Bauteil ein Transistor (M2) ist, der eine erste Hauptelektrode (S2), die mit dem Schaltungsknoten (N1) verbunden ist, und eine zweite Hauptelektrode (S2), die mit dem Schaltungsknoten (N1) verbunden ist, aufweist, wobei der Transistor (M2) vorgespannt ist, um den hohen Widerstandswert bereitzustellen.

6. Oszillatorschaltung gemäß einem der Ansprüche 1 bis 5, **dadurch gekennzeichnet, dass** das integrierte Bauteil einen mit einer Gate-Source-Spannung vorgespannten MOSFET-Transistor (M2) umfasst, wobei der MOSFET-Transistor eine mit dem Schaltungsknoten (N1) verbundene Source und einen mit dem invertierenden Eingang verbundenen Drain (D2) aufweist.

7. Oszillatorschaltung gemäß Anspruch 6, **dadurch gekennzeichnet, dass** der MOSFET-Transistor (M2) durch einen als Diode geschalteten zweiten MOSFET-Transistor (M1) vorgespannt ist, der eine mit dem Schaltungsknoten (N1) verbundene Source (S1), ein mit einem Gate (G2) des MOSFET-Transistors (M2) verbundenes Gate (G1) und einen Drain (D2), der mit einer vorspannenden Stromquelle ($I_B$) an dem Gate (G2) des zweiten MOSFET-Transistors (M1) verbunden ist, aufweist.

8. Oszillatorschaltung gemäß einem der Ansprüche 1 bis 7, **dadurch gekennzeichnet, dass** eine Eckfrequenz des Tiefpassfilters niedriger als 10 Hz ist.

9. Oszillatorschaltung gemäß einem der Ansprüche 1 bis 8, **dadurch gekennzeichnet, dass** der hohe Widerstandswert des Bauteils höher als 50 MΩ, vorzugsweise höher als 100 MΩ ist.

**Revendications**

1. Circuit intégré d'oscillateur à quartz compensé en température, comportant :

   un premier générateur (10) générant une première tension de commande dépendant de la température,
   un deuxième générateur (10) générant une deuxième tension de commande dépendant de la température,
   un amplificateur sommateur (31) comportant un amplificateur opérationnel (310) et ayant des première et deuxième entrées pour recevoir lesdites première et deuxième tensions de commande ($V_1$, $V_2$), respectivement, et une sortie pour délivrer en sortie une tension de somme ($V_{OUT}$) à utiliser en tant que tension de commande de fréquence ($V_{CNTRL}$),
   un troisième circuit (14) générant une tension de référence pour une entrée non-inverseuse dudit amplificateur opérationnel (310),
   un oscillateur à quartz commandé en tension (13) ayant une entrée de commande opérationnellement connectée pour recevoir ladite tension de commande de fréquence ($V_{CNTRL}$), **caractérisé en ce que** ledit amplificateur sommateur (31) inclut un filtre passe-bas intégré qui comporte :

   un composant intégré ($M_2$) ayant une valeur de résistance élevée, ledit composant ayant une première borne ($D_2$) reliée à une entrée inverseuse dudit amplificateur opérationnel (310), et une seconde borne ($S_2$) reliée à un noeud de circuit (N1) qui est de plus relié à ladite première entrée par l'intermédiaire d'une première résistance série ($R_1$) et à ladite seconde entrée par l'intermédiaire d'une seconde résistance série ($R_2$),
   un condensateur de rétroaction (C) connecté entre l'entrée inverseuse et la sortie dudit amplificateur opérationnel (310).

2. Circuit d'oscillateur selon la revendication 1, **caractérisé en ce qu'**il comporte un mécanisme de dérivation (M3) pour dériver ledit composant ($M_2$) au démarrage dudit circuit d'oscillateur.

3. Circuit d'oscillateur selon la revendication 2, **caractérisé en ce que** ledit mécanisme de dérivation comporte un transistor (M3) connecté entre ledit noeud de circuit (N1) et ladite entrée inverseuse et conçu pour être passant lors du démarrage du circuit d'oscillateur.

4. Circuit d'oscillateur selon la revendication 1, 2 ou 3, **caractérisé en ce que** ledit composant est un transistor MOSFET (M2) et ladite résistance élevée est la résistance à l'état passant dudit transistor MOSFET.

**5.** Circuit d'oscillateur selon la revendication 1, 2 ou 3, **caractérisé en ce que** ledit composant intégré comporte un transistor (M2) ayant une première électrode principale (S2) reliée audit noeud de circuit (N1), et un seconde électrode principale (D2) reliée à ladite entrée inverseuse, ledit transistor (M2) étant polarisé pour délivrer ladite valeur de résistance élevée.

**6.** Circuit d'oscillateur selon l'une quelconque des revendications 1 à 5, **caractérisé en ce que** ledit composant intégré comporte un transistor MOSFET (M2) polarisé à une tension grille-source, ledit transistor MOSFET (M2) ayant une source (S2) reliée audit noeud de circuit (N1), et un drain (D2) relié à ladite entrée inverseuse.

**7.** Circuit d'oscillateur selon la revendication 6, **caractérisé en ce que** ledit transistor MOSFET (M2) est polarisé par un second transistor MOSFET monté en diode (M1) ayant une source (S1) reliée audit noeud de circuit (N1), une grille (G1) reliée à une grille (G2) dudit transistor MOSFET (M2), et un drain (D2) relié à une source de courant de polarisation ($I_B$) à ladite grille (G2) dudit second transistor MOSFET (M1).

**8.** Circuit d'oscillateur selon l'une quelconque des revendications 1 à 7, **caractérisé en ce qu'**une fréquence de coupure dudit filtre passe-bas est inférieure à 10 Hz.

**9.** Circuit d'oscillateur selon l'une quelconque des revendications 1 à 8, **caractérisé en ce que** ladite valeur de résistance élevée dudit composant est supérieure à 50 Mohms, de préférence supérieure à 100 Mohms.

# Fig. 1

Summing amplifier

$10_1$ Block 1 $V_1$ $R_1$
$10_2$ Block 2 $V_2$ $R_2$
...
$10_N$ Block N $V_N$ $R_N$

$R_{FB}$

OA 110

11

$V_{OUT}$

14 Summing voltage reference
$V_C$

Scaling network 12 $V_{CNTRL}$ Voltage-controlled crystal oscillator 13 $f_O$

# Fig. 2

Amplitude

>130 dB

100 Hz

f

~13 MHz

~1 kHz

# Fig. 3

$10_1$ Block 1 $V_1$ $R_1$
$10_2$ Block 2 $V_2$ $R_2$
...
$10_N$ Block N $V_N$ $R_N$

$R_{FB}$

31

$S_1$ $D_1$
$M_1$ $G_1$
$M_2$ $G_2$ $R_{ON}$
$S_2$ $D_2$
$N_1$ $S_3$ $D_3$
$M_3$ $G_3$

$I_B$

C

310

$N_2$ OA

$V_{OUT}$

14 Summing voltage reference
$V_C$

Start-up circuit 15

Scaling network 12 $V_{CNTRL}$ Voltage-controlled crystal oscillator 13 $f_O$
$V_C$

8